# EUROPEAN PATENT SPECIFICATION

(11) **EP 0 275 212 B1**
(45) Date of publication and mention of the grant of the patent: **04.08.1993**
(21) Application number: 88300339.4
(22) Date of filing: 15.01.1988
(51) Int. Cl.: G11C 17/00

(54) **NAND stack ROM**
NAND-Stapelfestwertspeicher
Mémoire morte de type pile-NON-ET

(30) Priority: 16.01.1987 US 3837
(43) Date of publication of application: 20.07.1988
(73) Proprietor: GENERAL INSTRUMENT CORPORATION, New York New York 10153 (US)
(72) Inventor: Herdt, Christian E., Colorado Springs Colorado 80903 (US); Cliadakis Steven H., Mesa,Arizona 85202 (US)
(74) Representative: Tregear, George Herbert Benjamin

(56) References cited:
- US-A- 4 489 400
- US-A- 4 570 239

## Description

The present invention relates to electronic memories and, more particularly, to a NAND stack Read Only Memory, commonly called a NAND stack ROM. Such memories include an array of bit storage elements. The term NAND stack ROM array may be used to refer not only to the memory itself but to include those other circuit elements for addressing and reading data out of the array.

More particularly the invention relates to a NAND stack ROM of the kind in which addressable bit storage devices are formed in physically parallel, spaced columns on a semiconductor substrate, each column comprising a stack of said bit storage devices connected in series between first and second nodes, and the array further including means for pre-charging the first node of each stack, means for providing a ground connection for the second nodes of each stack, and means for sensing the potential at the first node of a stack when a bit storage device therein is addressed.

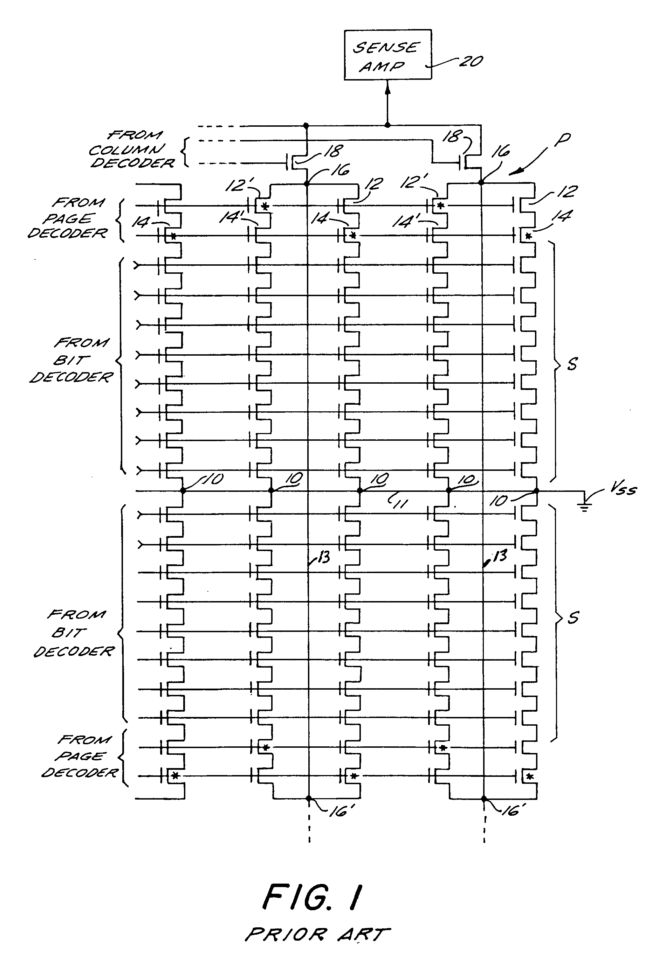

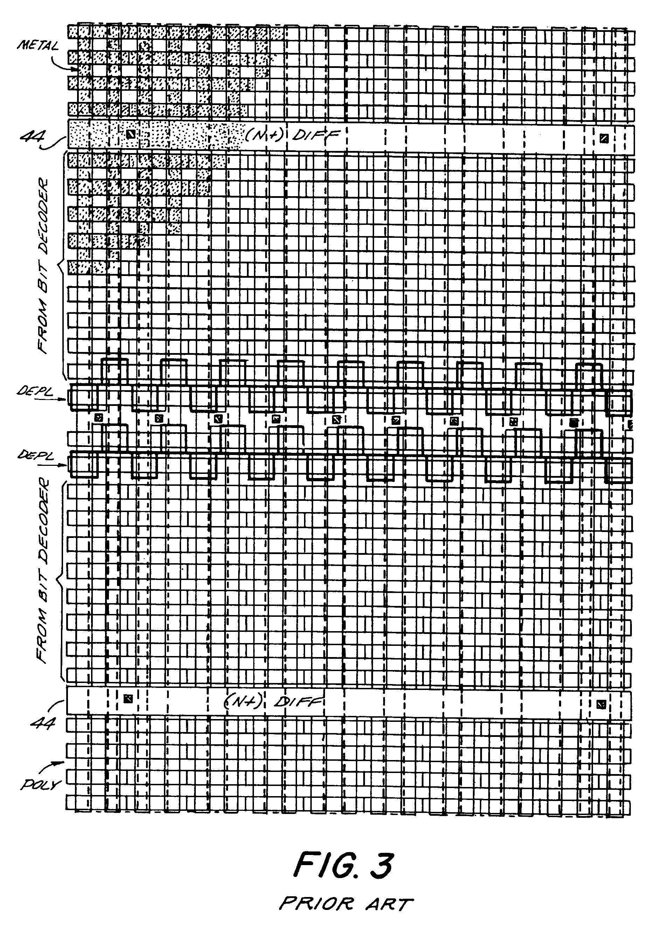

NAND stack ROM arrays generally consist of columns of series-connected, semiconductor devices. The devices are fabricated as either enhancement mode or depletion mode devices to reflect programmed data, that is the bit value to be stored by each device. In one conventional NAND stack ROM configuration, the stacks are configured in pairs, called "pages". Each page consists of two spaced parallel stacks of series connected bit transistors. Each page has a "one of two" multiplexer formed from four page decode transistors. Two page decode transistors are located at the end of each stack, a depletion mode transistor, and an enhancement mode transistor. To read data, the proper page decode line is brought high, accessing a particular page. Simultaneously, one of the bit decode lines is brought low and the input to the sense amplifier, which is selected by a multiplexer at the top of the array, either rises or falls. This conventional configuration is discussed further below with reference to Figs. 1 and 3 of the accompanying drawings.

A NAND stack ROM array that is not in a paged configuration is disclosed in U.S. patent 4,489,400 (Southerland). In this patent the first nodes of the columns of the array are individually connected to a decoder circuit through which the voltage sensing is performed when the array is addressed. The ground connection for discharging the columns upon addressing is provided simultaneously to all columns. This may lead to the disadvantages discussed in relation to the conventional array of Fig. 1. In that array the first nodes of the columns are permanently ground through a ground conductor. In U.S. patent 4,489,400 the grounding is through a switch device which may exacerbate interaction problems between discharging columns.

Both U.S. patent 4,489,400 and the paged array to be described with reference to Fig. 1 organize each column as two stacks of bit storage devices. In U.S. 4,489,400, the first node of a column is a common node at an intermediate point of the column. The first nodes are connected to a pre-charging source through individual switching transistors which are simultaneously activated. The end nodes of the column providing a respective end node for each stack, constitute second nodes. The second nodes at one end of the columns are connected together and to ground through a transistor switch and the second nodes at the other end of the columns are also connected together and to ground through a transistor switch. In the array of Fig. 1 the second nodes of the stacks in each column are a common intermediate point along the stack and the end nodes are the first, pre-chargeable, nodes. The end nodes of each column are connected together and the columns are taken in pairs with the end nodes of each pair connected together and selectively connectable to a voltage sensing amplifier through column decode gates. This is the page configuration already mentioned with a pair of page selection transistors in each stack. U.S. patent 4,489,400 discloses the use of a stack selection transistor for each stack.

It will be shown how the present invention can be implemented in a ROM array with just one enhancement mode selection transistor in each stack whereby each stack has one less decode transistor in it than the stack of a conventional NAND stack paged ROM with the same number of bits. Hence, a 256K array with 8-bit high stacks in a preferred configuration embodying the present invention has over 32,000 fewer transistors than a comparable array in the conventional arrangement. Furthermore, the implementation of the present invention has no need for horizontal ground straps of diffusion, required in the conventional layout.

There will be disclosed a memory design embodying the present invention which utilizes a dense array packing technique and lends itself to easy decoding. The design takes advantage of the increased packing density of the conventional NAND ROM configuration (over the more traditional NOR ROM configuration) and, at the same time, eliminates most of the multiplexing present in the conventional NAND ROM design. Accordingly, array size and capacitance are significantly reduced, leading to smaller chip dimensions and faster access times. Specifically column capacitance and hence column charge-up time are reduced.

Broadly stated, the present invention provides a NAND stack ROM array of the kind set forth above, characterised in that:
said means for providing a ground connection comprises a column decoder circuit having a plurality of column decode outputs selectively activatable to provide a virtual ground potential,
each column has associated therewith a device having a control terminal for controlling the connection of the first node of the column to said sensing means in response to the application of a virtual ground potential to the respective control terminal,
each second node of a column and the respective control terminal of the associated connection device is connected to one of the column decode outputs by means of a substrate conductor that extends between and in the direction of that column and a next adjacent column.

This basic structure and its interconnection may be advantageously put into practice in a ROM array in which the sensing means comprises first and second voltage sensing amplifiers. The substrate conductor is also connected to the second node of the next adjacent column and the control terminal of the connection device associated therewith. The first nodes of these two columns, between which the substrate conductor extends, are connected through respective connection devices to different ones of the sensing amplifiers. Thus these two columns form a pair connected to the same column decode output but with their first nodes associated with different voltage sensing amplifiers.

Furthermore it is preferred that a pair of next adjacent columns, which are connected to different column decode outputs have their first nodes connected together through a common connection device to one of said sensing amplifiers; To meet the requirements stated in the preceding paragraph, a next adjacent such pair of columns in the array is connected to the other of the sensing amplifiers.

As will become clear from the embodiment described below, the common connection device of a pair of columns connected in accordance with the immediately preceding paragraph, may be a pair of parallel connected transistors, each associated with a respective column of the pair by having its control terminal, e.g. gate electrode, connected to the column decode output for the respective column. This form of common connection device having two inputs is referred to later as a "multiplexer".

The NAND stack ROM array of the invention may have each column comprise two colinearly aligned stacks. The respective first nodes of the two colinear stacks in a column are connected in common and the respective second nodes of the two stacks are connected in common. Each stack also comprises a stack selection device connected in series with the bit storage devices of the stack between its first and second nodes, and each such selection device comprises a single enhancement mode transistor. More particularly in the embodiment to be described, in each column the respective second nodes of the two stacks are constituted by a common intermediate node along the stack and the first nodes are the end nodes of the column.

In the embodiment to be described, the pre-charging means of the ROM is connected to pre-charge all the first nodes simultaneously.

It is to be understood that for the purposes of this disclosure the term "substrate" includes a well or other suitable structure.

In order that the invention and its practice may be better understood an embodiment of it will now be described with reference to the accompanying drawings and contrasted with a conventional paged ROM array already discussed above and also illustrated in the drawings, in which:
Fig. 1 is a schematic diagram of a conventional paged NAND stack ROM;
Fig. 2 is a schematic diagram for the NAND stack ROM of the present invention;
Fig. 3 is an idealized chip layout design for the NAND stack ROM illustrated in Fig. 1; and
Fig. 4 is an idealized chip layout for the NAND stack ROM illustrated in Fig. 2.

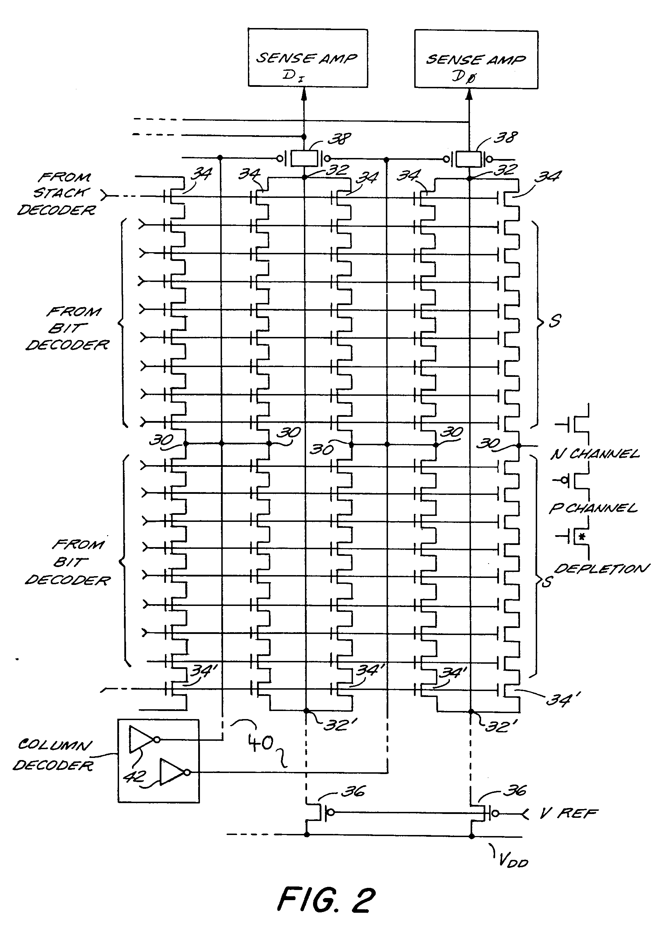

In the figures, like numerals refer to like parts, and Fig. 2 includes an illustration at the right of the figure of the symbols used for different types of transistor.

As seen in Fig. 1, a conventional NAND stack ROM includes a substrate or well in which the array is formed. The array includes a plurality of pages, generally designated P, consisting of adjacent stacks S. Each stack S consists of, for example, eight N-channel bit transistors. Colinear stacks S form columns. Each stack S is operably connected between an intermediate node 10 connected to ground by a horizontal diffusion strip 11 and a pair of page decode transistors 12, 14 and 12ʹ, 14ʹ, respectively, one of which is an enhancement mode transistor, and the other of which is a depletion mode transistor. Each pair of page decode transistors 12, 14 and 12ʹ, 14ʹ are interposed between the stack and an end node 16, 16ʹ. End nodes 16 and 16ʹ are electrically interconnected by vertical metal lines 13. Node 16 is connected through an N-channel decoder transistor 18 to a sense amplifier 20. Node 16ʹ is connected to the output of a column select circuit. The column select circuit preferably serves to precharge the nodes 16, 16ʹ of a selected column. This optimizes the speed of the ROM.

Thus, each page includes two stacks consisting of, for example, 8 bit transistors each and a "one of two" multiplexer comprised of the four page decode transistors 12, 14 and 12ʹ, 14ʹ. To read data from the memory, the column select circuit precharges a selected column by applying a voltage to the node 16, 16ʹ associated therewith. The selected page decode line is then brought high, accessing either the right or left stack of a particular page. Simultaneously, one of the bit decode lines is brought low and the input to the sense amplifier 20, which is selected by the multiplexer 18 at the top of the array, either rises or falls, depending upon whether the selected stack has become conductive, thereby connecting node 16 or 16ʹ with grounded node 10. If the stack has been conductive, then the charge on the node 16, 16ʹ will dissipate to ground. Otherwise, node 16, 16ʹ will remain charged. This is sensed by sense amplifier 20 through transistor 18.

As best seen in Fig. 2, in the ROM embodying the present invention, the stacks are not configured in pairs. This eliminates the need for the page decode depletion transistors 14, 12ʹ. Each column includes colinear stacks S of (for example) eight N-channel bit transistors with an intermediate node 30 and end nodes 32, 32ʹ. A single enhancement node stack decode transistor 34, 34ʹ is interposed between the stack and node 32, 32ʹ. Preferably, nodes 32ʹ are connected to a voltage source V_{DD} through a P-channel transistor 36, the input terminal of which is conditionally connected to a voltage reference source V_{REF}. This permits the ROM to operate at maximum speed. Node 32 of each column is connected through a pair of parallel P-channel transistors 38 to a sense amplifier.

Nodes 30 are connected to conductive metal lines 40 which run vertically through the substrate. Preferably, lines 40 are parallel to, but spaced from, the columns. Each of the lines 40 extends from the output of a column decoder 42 which applies a "virtual ground" signal of approximately 0 volts to the line when it is selected (otherwise, applies a "high"). Line 40 is connected to nodes 30 of adjacent columns and also to the inputs of P-channel decoder transistors 38.

A particular row of stacks is accessed by bringing the stack decode line high such that the stack decode transistor 34, 34ʹ of the selected stack S is turned on. A column is selected by bringing a virtual ground line 40 associated therewith to a low state. To read the data, one of the bit lines is brought low at the same time as the stack is accessed and the column is selected. The input of the sense amplifier, connected through multiplex transistors 38 at the top of the column, either rises or falls.

It can now be appreciated that the ROM of Fig. 2 has one less (depletion mode page decode) transistor in it than the conventional NAND stack ROM configuration with the same number of bits. Hence, a 256K array with 8 bit high stacks in the configuration of the present invention has over 32,000 fewer transistors of a comparable conventional array.

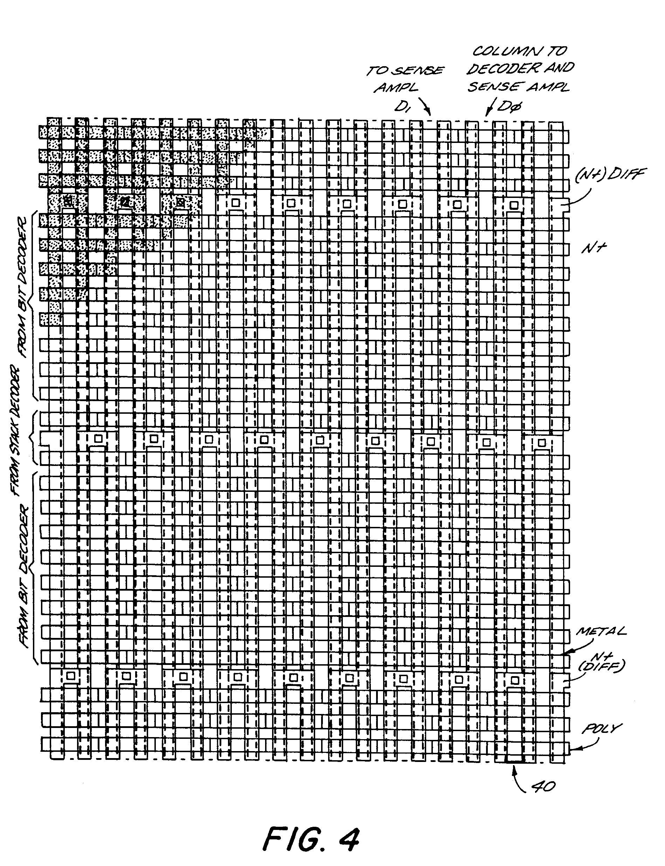

Figs. 3 and 4 shows chip layouts for the conventional NAND stack ROM and the ROM embodying the present invention, respectively. A comparison of Figs. 3 and 4 indicates that since the virtual ground lines 40 run vertically through the array illustrated in Fig. 4, there is no need for the horizontal ground straps of N+ diffusion 44, shown in Fig. 3. In addition, the depletion mode transistors 14, 12ʹ are also eliminated. These two differences make the array of Fig. 4 about 10% shorter than a comparable conventional array when drawn with the same set of design rules.

In addition, the depletion page decode transistor 14, 12ʹ in the conventional array and its longer array size add to column capacitance. In the present design, the columns are 40% less capacitive as calculated using the same design rules and process parameters. This translates into a 12%-20% decrease in column charge-up time, depending upon the column operating voltage.

As seen in Fig. 2, adjacent columns in the array are tied to alternating sense amplifiers, D_{I} and D_{φ} in the same way as X matrix ROM columns are organized. Interference between a column being selected and adjacent columns as well as sneak paths, which are common problems in X matrix ROM design, are significantly reduced.

The multiplex transistors 38 are actuated by the same virtual ground lines 40 running vertically up the array. These metal virtual ground lines 40 do not increase the array's width since the array's horizontal axis is diffusion limited in the process technology used to develop the invention. In the conventional array, by contrast, the multiplexer is gated by lines running horizontally along the top of the array, using extra chip area. Because of the dual purpose virtual ground lines 40, a column in the array of Fig. 2 may have only one multiplexing transistor 34, 34' to pass before the input of its sense amplifier, yet a 256K chip may have as few as one sense amplifier per output without increasing chip size.

In addition, it should be appreciated that the array design of figs. 2 and 4 is technology independent. While the circuit disclosed herein is a CMOS implementation of an array of the present invention, it should be appreciated that the same concepts can be used in conjunction with an NMOS implementation. The design now proposed will reduce power consumption in NMOS ROMs which limit multiplexing at the top of the array by using more than one sense amplifier per output.

It can now be appreciated that the virtual ground NAND stack ROM design described with reference to Figs. 2 and 4 substantially reduces array size and column capacitance, hence decreasing total chip area and column charge-up time. It also combines the advantages of single transistor multiplexing at the top of the array with the lower power consumption of few sense amplifiers, without increasing the area of the circuitry peripheral to the array. The implementation of the design embodying the present invention is expected to significantly improve wafer yields.

Referring again to Figs. 2 and 4 it will be seen that the array organisation and structure provides that one conductor 40 extending between and in the direction of a pair of next adjacent columns is connected to both columns. Specifically it is connected to the nodes 30 and to the control inputs of one half of each of the respective multiplexers 38 associated with those columns so that, upon the relevant control output of the column decoder 42 providing virtual ground potential to the connected nodes 30, it also make a connection through one of the parallel paths in the relevant multiplexer to connect each column of the pair to a different sense amplifier. Each multiplexer comprises two parallel-connected P-channel transistors the respective gates of which provide the two control inputs for the multiplexer.

Another pair structure can also be discerned in Fig. 2. Each column of a pair that shares a common virtual ground conductor 40, also forms another sort of pair with next adjacent the column on its other side. In these other pairs, the end nodes 32 are connected together as are the end nodes 32' and a conductor extends between these two columns to connect all the end nodes together. At the top of the array, as seen in the figures, the common end node is connected to a respective one of the sense amplifiers D₁ or Dφ, through a multiplexer 38. Thus columns of these other pairs share end nodes but their nodes 30 are connected to different column decode outputs. It will also be seen that whereas one of these other column pairs is connected to one of the sense amplifiers, e.g. D₁, the next adjacent such pair is connected to the other of the sense amplifiers, D_{φ}
The end nodes 32, 32' of all the columns are precharged simultaneously through the transistors 36 controlled by VREF. A respective transistor 36 is connected between the voltage source V_{DD} and each common pre-charge node of one of the other column pairs.

All the features of the ROM design of Figs. 2 and 4 that have been described above aid toward achieving a dense array packing technique and an array that lends itself to easy decoding.

## Claims

1. A NAND stack ROM in which addressable bit storage devices are formed in physically parallel, spaced columns on a semiconductor substrate, each column comprising a stack (5) of said bit storage devices connected in series between first (32) and second (30) nodes, and the ROM further including means (36) or pre-charging the first node of each stack, means (42) providing a ground connection for the second node of each stack, and means for sensing the potential at the first node of a stack when a bit storage device therein is addressed, characterised in that:
said means for providing a ground connection comprises a column decoder circuit having a plurality of column decode outputs (42) selectively activatable to provide a virtual ground potential,
each column has associated therewith a device (38) having a control terminal for controlling the connection of the first node (32) of the column to said sensing means in response to the application of a virtual ground potential to the respective control terminal,
each second node (30) of a column and the respective control terminal of the associated connection device (38) is connected to one of the column decode outputs (42) by means of a substrate conductor (40) that extends between and in the direction of that column and a next adjacent column.

2. A NAND stack ROM as claimed in Claim 1, in
which said sensing means comprises first (D₁) and second (D_{φ}) voltage sensing amplifiers, the stacks (S) of two columns between which said substrate conductor (40) extends have their respective first nodes (32) connected to different ones of the sensing amplifiers (D₁, D_{φ}) through respective connection devices (38), and said substrate conductor (40) is connected to the second nodes (30) of, and to the respective control terminals associated with, both the two columns between which said substrate conductor (40) extends.

3. A NAND stack ROM as claimed in Claim 2, in which the stacks (S) of a pair of next adjacent columns, which are connected to different column decode outputs (42), have their first nodes (32) connected together through a common connection device (38) to one (E.G. D₁) of said sensing amplifiers.

4. A NAND stack ROM as claimed in Claim 3 in which each connection device (38) is a multiplexer having two inputs connected to respective ones of said different column decode outputs (42).

5. A NAND stack ROM as claimed in any preceding claim which each column comprises two colinearly aligned stacks (S) having their respective first nodes (32, 32') connected in common and their respective second nodes (30) connected in common, and wherein each stack further comprises a stack selection device (34) connected in series with the bit storage devices of the stack between its first and second nodes thereof, and each stack selection device (34) comprises a single enhancement mode transistor.

6. A NAND stack ROM as claimed in Claim 5 in which in each column said respective second nodes (30) are constituted by a common intermediate node (30) along the column and the first nodes (32, 32') are end nodes of the column.

7. A NAND stack ROM as claimed in any one of Claims 1 to 6, in which said pre-charging means (V_{DD}, 36) is connected to pre-charge all of said first nodes (32, 32') simultaneously.

## Patentansprüche

1. NAND-STAPEL-ROM in welchem auf einem Halbleitersubstrat adressierbare Bitspeicherbauelemente in baulich parallelen beabstandeten Spalten ausgebildet sind, wobei jede Spalte einen Stapel (S) von zwischen einem ersten (32) und einem zweiten (30) knoten in Reihe geschalteten Bitspeicherbauelementen aufweist und das ROM weiterhin Mittel (36) zum Voraufladen des ersten Knotens jedes Stapels, Mittel (42) zum Schaffen einer Masseverbindung für den zweiten Knoten jedes Stapels und Mittel zum Lesen des Potentials des ersten Knotens eines Stapels, wenn ein darin befindliches Bitspeicherbauelement adressiert wird, aufweist,
**dadurch gekennzeichnet**, daß
die Mittel zum Schaffen einer Masseverbindung eine Spaltendecodierschaltung mit mehreren Spaltendecodierausgängen (42) die zur Erzeugung eines virtuellen Massepotentials selektiv aktivierbar sind, aufweisen,
jeder Spalte ein Bauelement (38) zugeordnet ist, welches einen Steueranschluß zum Steuern der Verbindung des ersten Knotens (32) der Spalte mit den Lesemitteln in Abhängigkeit des Anlegens eines virtuellen Massepotentials an den jeweiligen Steueranschluß aufweist,
jeder zweite Knoten (30) einer Spalte und der jeweilige Steuereingang des zugehörigen Verbindungsbauelements (38) mittels eines Substratleiters (40) welcher sich zwischen und in Richtung dieser Spalte und einer nächst-benachbarten Spalte erstreckt, an einen der Spaltendecodierausgänge (42) angeschlossen ist.

2. **NAND-STAPEL-ROM** nach Anspruch 1, in welchem die Lesemittel aufweisen: einen ersten (D_{I}) und einen zweiten (D_{φ}) Spannungsleseverstärker wobei die Stapel (S) von zwei Spalten, zwischen denen sich der Substratleiter (40) erstreckt, mit ihren jeweiligen Knoten (32) an unterschiedliche Leseverstärker (D_{I},D_{φ}) über jeweilige Verbindungsbauelemente (38) angeschlossen sind und der Substratleiter (40) mit den zweiten Knoten beider Spalten zwischen denen sich der Substratleiter (40) erstreckt und mit den diesen beiden Spalten zugehörigen jeweiligen Steueranschlüssen verbunden ist.

3. **NAND-STAPEL-ROM** nach Anspruch 2, bei dem die Stapel (S) eines Paares nächst-benachbarter Spalten die an verschiedene Spaltendecodierausgänge (42) angeschlossen sind mit ihren ersten Knoten (32) über ein gemeinsames Verbindungsbauelement (38) an einen (z.B. DI) der Leseverstärker gemeinsam angeschlossen sind.

4. **NAND-STAPEL-ROM** nach Anspruch 3, bei dem jedes Verbindungsbauelement (38) ein Multiplexer ist der mit zwei Eingängen an die jeweiligen der verschiedenen Spaltendecodierausgänge (42) angeschlossen ist.

5. **NAND-STAPEL-ROM** nach irgendeinem vorhergehenden Anspruch, bei dem jede Spalte zwei kolinear ausgerichtete Stapel (S) aufweist, die mit ihren jeweiligen ersten Knoten (32,32') zusanunengeschaltet sind und mit ihren jeweiligen zweiten Knoten (30) zusammengeschaltet sind wobei jeder Stapel außerdem ein Stapelauswahlbauelement (34) aufweist welches in Reihe mit den Bitspeicherbauelementen des Stapels zwischen dessen erstem und zweitem Knoten geschaltet ist, und jedes Stapelauswahlbauelement (34) einen einzelnen Transistor vom Anreicherungstyp aufweist.

6. **NAND-STAPEL-ROM** nach Anspruch 5, bei dem in jeder Spalte die jeweiligen zweiten Knoten (30) gebildet werden durch einen gemeinsamen Zwischenknoten (30) entlang der Spalte, und die ersten Knoten (32, 32') Endknoten der Spalte sind.

7. **NAND-STAPEL-ROM** nach irgendeinem der Ansprüche 1 bis 6, bei dem die Vorauflademittel (VDD, 36) so verschaltet sind, daß sie sämtliche ersten Knoten (32,32') gleichzeitig voraufladen.

## Revendications

1. Mémoire morte à piles NON-ET dans laquelle des dispositifs de stockage de bits adressables sont constitués sur un substrat semi-conducteur sous la forme de colonnes physiquement parallèles, espacées, chaque colonne comprenant une pile (S) desdits dispositifs de stockage de bits montés en série entre des premiers (32) et des seconds (30) noeuds, et la mémoire morte comportant en outre un moyen (36) pour pré-charger le premier noeud de chaque pile, un moyen (42) pour réaliser une mise à la terre pour le second noeud de chaque pile, et un moyen pour détecter le potentiel au premier noeud d'une pile lorsqu'un dispositif de stockage de bits présent dans celle-ci est adressé, caractérisée en ce que:
ledit moyen pour établir une mise à la terre comprend un circuit de décodage de colonnes ayant une pluralité de sorties (42) de décodage de colonnes pouvant être sollicitées d'une manière sélective pour réaliser un potentiel de terre virtuel,
à chaque colonne correspond un dispositif (38) ayant une borne de commande pour commander la connexion du premier noeud (32) de la colonne avec ledit moyen de détection en réponse à l'application d'un potentiel de terre virtuel à la borne de commande correspondante,
chaque second noeud (30) d'une colonne et la borne de commande respective du dispositif de connexion correspondant (38) sont reliés à une des sorties (42) de décodage de colonnes par l'intermédiaire d'un conducteur (40) du substrat qui s'étend entre et dans la direction de cette colonne et d'une colonne immédiatement voisine.

2. Mémoire morte à piles NON-ET selon la revendication 1, dans laquelle ledit moyen de détection comprend un premier (D_{I}) et un second (D_{φ}) amplificateurs de détection de tension, les piles (S) de deux colonnes entre lesquelles s'étend ledit conducteur (40) du substrat ont leurs premiers noeuds respectifs (32) reliés à des amplificateurs de détection différents (D_{I}, D_{φ}) par l'intermédiaire de dispositifs de connexion correspondants (38), et ledit conducteur (40) du substrat est relié aux seconds noeuds (30), ainsi qu'aux bornes de commande respectives correspondant aux deux colonnes entre lesquelles s'étend ledit conducteur (40) du substrat.

3. Mémoire morte à piles NON-ET selon la revendication 2, dans laquelle les piles (S) d'une paire de colonnes immédiatement voisines, qui sont reliées à différentes sorties de décodage (42) de colonnes, ont leurs premiers noeuds (32) reliés ensemble, par l'intermédiaire d'un dispositif de connexion commun (38), à l'un (par exemple, D_{I}) desdits amplificateurs de détection.

4. Mémoire morte à piles NON-ET selon la revendication 3, dans laquelle chaque dispositif de connexion (38) est un multiplexeur ayant deux entrées reliées à des sorties respectives parmi lesdites sorties différentes (42) de décodage de colonnes.

5. Mémoire morte à piles NON-ET selon l'une quelconque des revendications précédentes, dans laquelle chaque colonne comprend deux piles (S) alignées d'une manière colinéaire ayant leurs premiers noeuds respectifs (32, 32') reliés en commun et leurs seconds noeuds respectifs (30) reliés en commun, et dans laquelle chaque pile comprend en outre un dispositif (34) de sélection de piles monté en série avec les dispositifs de stockage de bits de la pile entre ces premiers et seconds noeuds, et chaque dispositif (34) de sélection de piles comprend un transistor unique en mode enrichissement.

6. Mémoire morte à piles NON-ET selon la revendication 5, dans laquelle, dans chaque colonne, lesdits seconds noeuds respectifs (30) sont constitués par un noeud intermédiaire commun le long de la colonne et les premiers noeuds (32, 32') sont des noeuds d'extrémités de la colonne.

7. Mémoire morte à piles NON-ET selon l'une quelconque des revendications 1 à 6, dans laquelle ledit moyen de pré-chargement (V_{DD}, 36) est connecté pour précharger simultanément la totalité desdits premiers noeuds (32, 32').
